Europäisches Patentamt

European Patent Office

Office européen des brevets

(11) Publication number: **0 115 184**
**B1**

(12) EUROPEAN PATENT SPECIFICATION

(45) Date of publication of patent specification: **19.11.87**

(21) Application number: **83307873.6**

(22) Date of filing: **22.12.83**

(51) Int. Cl.⁴: **G 03 B 41/00**

(54) **An automatic focus control device.**

(30) Priority: **28.12.82 JP 228703/82**

(43) Date of publication of application:
**08.08.84 Bulletin 84/32**

(45) Publication of the grant of the patent:
**19.11.87 Bulletin 87/47**

(84) Designated Contracting States:
**DE FR GB**

(56) References cited:
**EP-A-0 031 680**
**EP-A-0 063 980**
**FR-A-2 506 960**
**GB-A-2 052 090**
**US-A-3 712 740**

(73) Proprietor: **FUJITSU LIMITED**
**1015, Kamikodanaka Nakahara-ku**
**Kawasaki-shi Kanagawa 211 (JP)**

(72) Inventor: **Iijima, Nobuo**
**12-401, 6, Kaitori 2-chome**
**Tama-shi Tokyo 206 (JP)**

(74) Representative: **Fane, Christopher Robin King**
**et al**
**HASELTINE LAKE & CO. Hazlitt House 28**
**Southampton Buildings Chancery Lane**
**London, WC2A 1AT (GB)**

# 0 115 184

## Description

The present invention relates to an automatic focus control device, for example for use in exposure apparatus in the production of an integrated circuit.

Recent research and development projects in the field of integrated circuits (IC's) and large-scale integrated circuits (LSI's) have concentrated on the achievement of greater miniaturization of the elements and higher integration of the circuit patterns. In the production of these IC's, the so-called stepper exposure apparatus equipped with a reduction lens is used to expose a wafer. In this process, the focal depth of the reduction lens is usually in the range of about 1 μm. However, the surface of the wafer usually has several bumps or depressions, and the depth of these bumps or depressions is usually in the range of from 5 μm as a minimum value to 10 μm as a maximum value. For this reason, it is necessary to repeatedly adjust the focus of the reduction lens corresponding to the height of the surface of the wafer by an automatic adjustment. In order to automatically adjust the focus, it is necessary to precisely measure the height from the reduction lens of the wafer to be exposed.

Well-known techniques for measuring the height of the wafer to be exposed include using an air-micrometer or utilizing electrostatic capacity. In the case of the air-micrometer, the air used for measuring the height cannot be blown against the center portion of the exposing portion because a light beam used for exposing the wafer is located at that portion. Therefore, in order to measure the height of the exposing portion of the wafer, the air used for measuring the height is blown against the peripheral portion thereof. The height of the center portion of the exposing portion is then estimated from the values obtained when measuring the height of the peripheral portion. Where electrostatic capacity is used, as for the air-micrometer, a sensor for measuring the electrostatic capacity cannot be provided on the center portion of the exposing portion, therefore, the height of the center portion of the exposing portion is similarly estimated from the values obtained when measuring the height of the peripheral portion.

Further, when one of the chips located near the edge of the wafer on an X—Y table is exposed by the light beam, and because one air-micrometer or electrostatic capacity sensor is provided to the wafer side and the other air-micrometer or electrostatic capacity sensor is provided to the X—Y table side, problems occur in that as the air-micrometer or the sensor provided to the X—Y table side cannot detect the height of the chips to be exposed, and the surface of the wafer may be damaged by the descent of the reduction lens.

In one attempt to solve the above-mentioned problems, a method for detecting the height of the wafer using reflected rays, i.e., the so-called focus detecting method utilizing reflected rays, is used.

However, problems also occur when this method is used, as will appear from the following description of a conventional focus adjusting device and optical system using this method, with reference to Figs. 1 to 3 of the accompanying drawings, in which:

Fig. 1 is a schematic side view of a light detecting means of a conventional focus adjusting device and optical system; and

Figs. 2 and 3 are schematic side views of a wafer indicating the relationship between the incident rays and reflected rays.

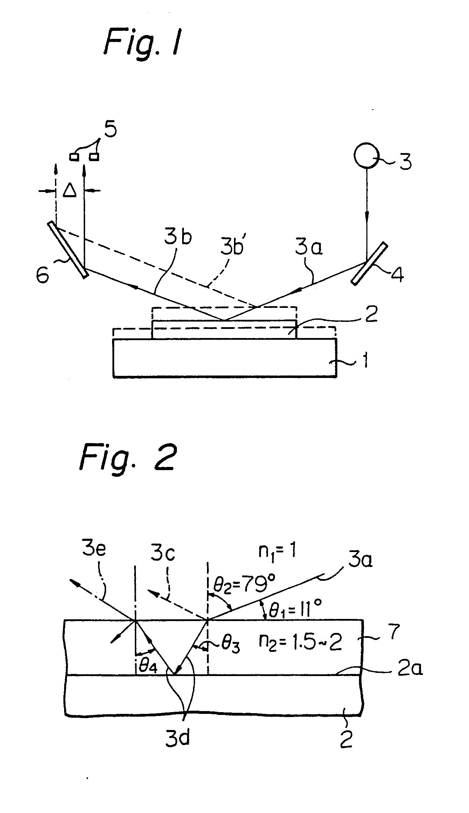

Referring to Fig. 1, the wafer 2 is provided on the X—Y table. The incident rays 3a emitting from the light emitting means 3 are reflected by the reflecting mirror 4, and by the wafer 2. The reflected rays 3b are again reflected by the reflecting mirror 6 and detected by the detecting means 5, to determine the surface conditions of the wafer 2. Assuming that the surface of the wafer 2 moves to the position indicated by the dotted line, the incident rays 3a are reflected by the surface indicated by the dotted line, and the reflected rays 3b' (dotted line) are reflected by the reflecting mirrors 6 and detected by the detecting means 5. The bumps or depressions on the surface of the wafer 2, i.e., the changes in height from the surface of the wafer 2, can be detected by measuring the gap $\Delta$ between the reflected rays 3b and the reflected rays 3b'.

Referring to Fig. 2 when a transparent film 7 having the refractive index $n_2$ ($n_2$=1.5 to 2) is located on the reflecting face 2a of the wafer 2, one part of the incident rays 3a is reflected by the transparent film 7 as shown by 3c, the other part of the incident rays 3a (shown by 3d) is transmitted to the inside of the transparent film 7 and is reflected by the reflecting face 2a. The reflected rays 3d are transmitted again to the outside of the transparent film 7, and appear outside the film 7 having the refractive index $n_1$ ($n_1$=1) as shown by 3e. Since the detecting means 5 simultaneously detect these reflected rays 3c and 3e, they cannot precisely detect the difference between 3c and 3e.

As shown in Fig. 2, the incident angle $\theta_1$ of the incident rays 3a is usually $\theta_1$=11° for the conventional stepper exposure apparatus. In this case, the refractive angle $\theta_3$ in the transparent film 7 is obtained by the following formula,

$$n_1 \cdot \sin 79° = n_2 \cdot \sin \theta_3 \tag{1}$$

where, the refractive index $n_1$=1 and $n_2$=1.5 to 2, $\therefore$

$$\theta_3 = 40.9° \text{ to } 29.4°$$

namely,

$$\theta_3 = 40.9° \text{ (at } n_2 = 1.5)$$

$$\theta_3 = 29.4° \text{ (at } n_2 = 2).$$

2

Next, the critical angle $\theta_4$ of the reflected rays 3d is obtained by the following formula,

$$n_2 \cdot \sin \theta_4/n_1 = 1 \qquad\qquad (2)$$

where, $n_1 = 1$, $n_2 = 1.5$ to $2$

$$\theta_4 = 41.8° \text{ to } 30°$$

namely,

$$\theta_4 = 41.8° \text{ (at } n_2 = 1.5)$$

$$\theta_4 = 30° \text{ (at } n_2 = 2).$$

As can be seen from the above-mentioned calculation, the critical angle $\theta_4$ (at $n_2 = 2$) of the reflected rays 3d is approximately equal to the refractive angle $\theta_3$ (at $n_2 = 2$). However, this means that these angles cause a total reflection to occur on the surface of the resist coating at the incident angle $\theta_1 = 11°$. Thus the incident angle $\theta_1 = 11°$ at which occurs the total reflection is not an appropriate angle.

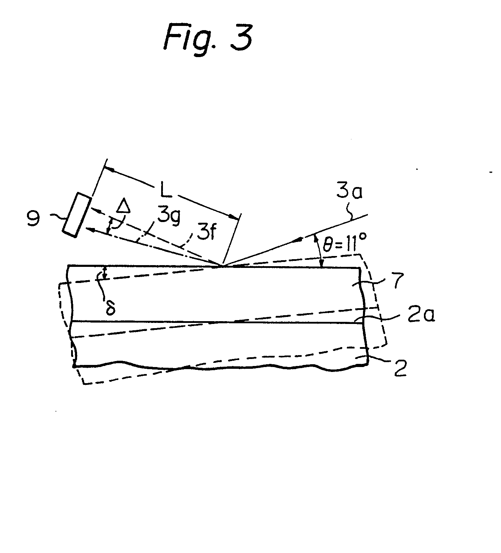

Other problems are explained with reference to Fig. 3. Referring to Fig. 3, when the surface of the resist coating film 7 is inclined, as shown by the dotted line, the reflected rays 3f change direction to the line shown by 3g according to the inclined angle $\delta$ of the surface of the film. Thus, the detecting means 5 detect the error by the gap $\Delta$ between the reflected rays 3f and 3d.

A focus control device has also be proposed in EP—A—0 063 980 in which two light sources and two pairs of photodetectors are arranged symmetrically on opposite sides of the axis of the light beam, together with means for focussing the light from the sources on the wafer at the desired height and refocussing the reflected light on the respective pair of photodetectors. An error signal is obtained by forming the differences in the amounts of light incident on the two photodetectors of each pair due to departures of the wafer surface from the desired height and summing these differences, and this signal is used to control the adjustment of the height of the X—Y table to correct the error.

The object of the present invention is to provide an automatic focus control device for use in an exposure apparatus that is insensitive to inclination of the surface of a sample and to uneven reflectivity of the surface in the region of the focal point of the exposure apparatus.

The device according to the invention comprises:

a first light emitting means for directing a first light ray onto a sample;

a second light emitting means for directing a second light ray onto said sample;

a first light detecting means for detecting said second light ray reflected by a surface of said sample, said first light detecting means being composed of a first light detecting element and a second light detecting element;

a second light detecting means for detecting said first light ray reflected by said surface of said sample, said second light detecting means being composed of a third light detecting element and a fourth light detecting element;

wherein said first light emitting means and said first light detecting means are located at a position symmetric to said second light emitting means and said second light detecting means with regard to a centre axis of a light beam for exposing said sample;

and means for computing the height position of the surface of said sample with respect to the position of the focus of the said exposing light beam on the basis of the output of said first and second light detecting means;

said computing means comprising a first adder for adding the outputs of said first light detecting element land of said fourth light detecting element, a second adder for adding the output of said second light detecting element and of said third light detecting element, a subtractor for forming the difference between the output of said first adder and the output of said second adder and a smoothing circuit for smoothing the output of said subtractor for use as a signal for adjusting the relative height position between the focus of said exposure light beam and the surface of said sample;

whereby the output of said computing means is insensitive to an inclination of said surface of the sample and to uneven reflectivity of said surface in the region of the focal point.

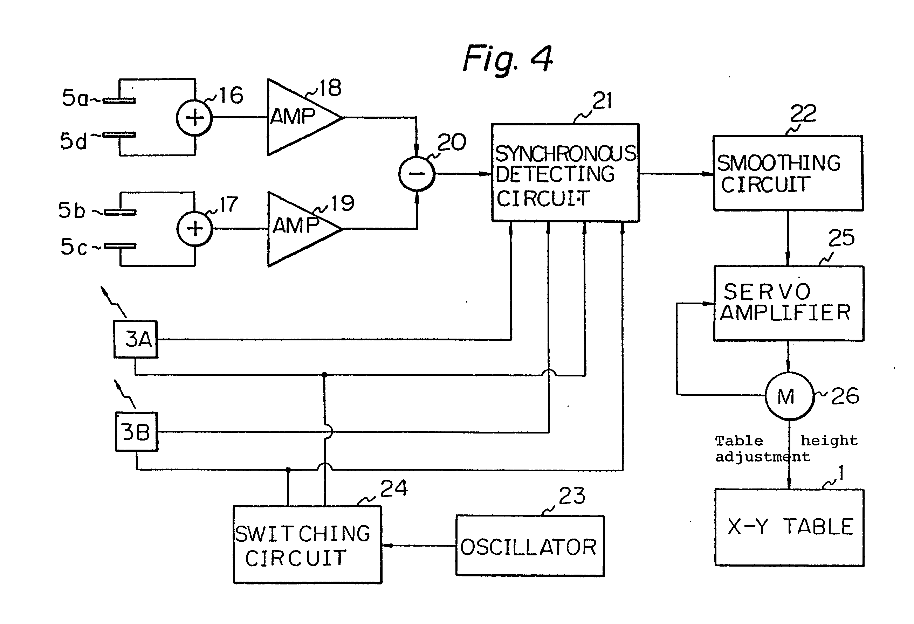

An automatic focus control device according to an embodiment of the present invention will now be described with reference to Figs. 4 to 12 of the accompanying drawings, in which:

Fig. 4 is a basic block diagram of an automatic focus control device according to an embodiment of the present invention;

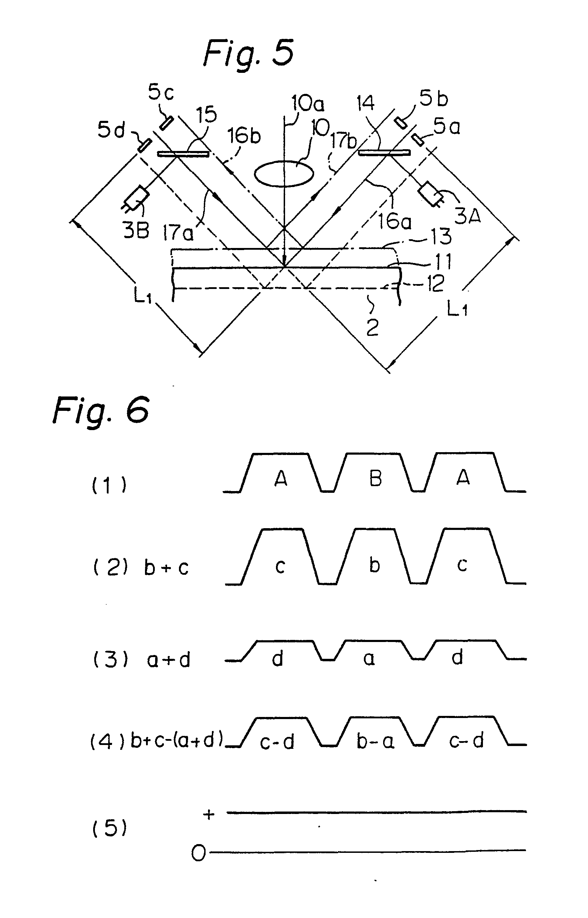

Fig. 5 is a schematic side view of an optical system of the device shown in Fig. 4;

Figs. 6 to 8 are waveform charts obtained from the optical system shown in Fig. 5;

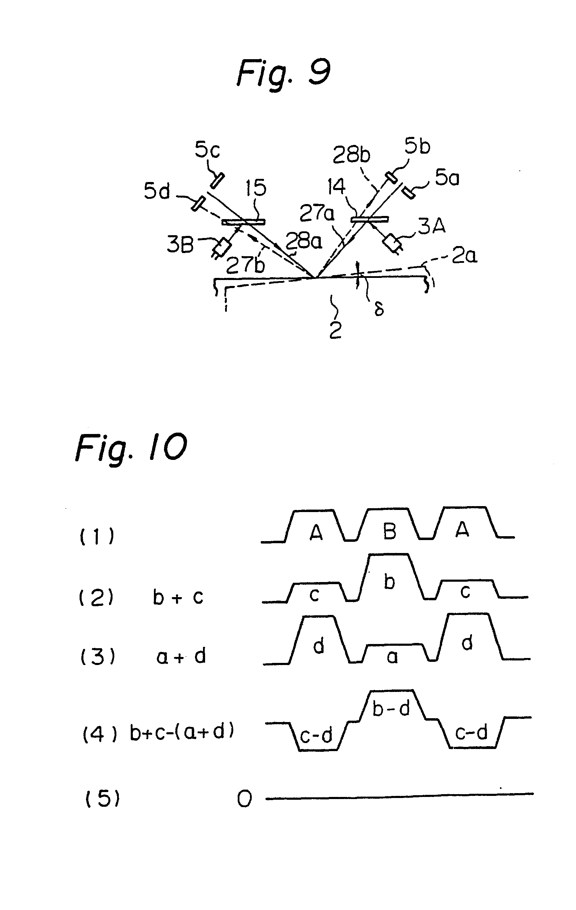

Fig. 9 is a schematic side view of the optical system in the case of an inclined wafer, regarding the wafer shown in Fig. 5;

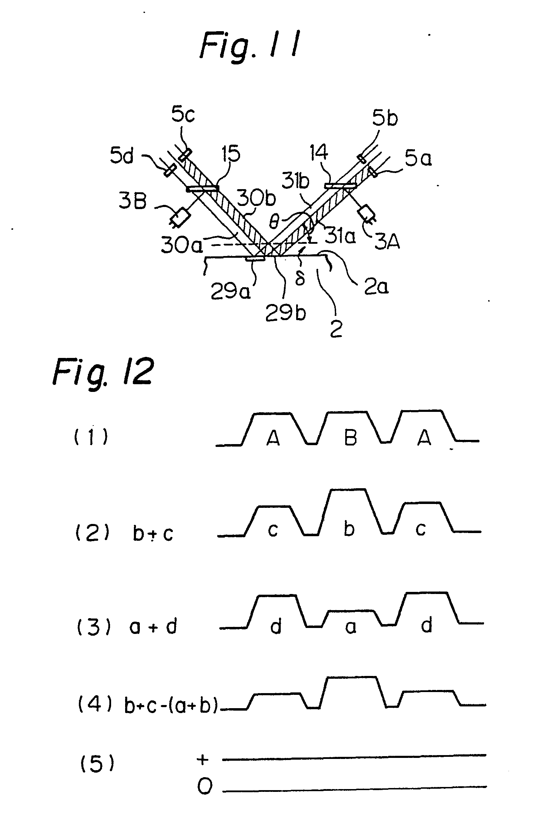

Fig. 10 is a waveform chart obtained from the optical system shown in Fig. 9;

Fig. 11 is a schematic side view of the optical system in the case of the focal surface of the wafer having different reflectivity, regarding the wafer shown in Fig. 5; and

Fig. 12 is a waveform chart obtained from the optical system shown in Fig. 11.

Referring to Figs. 4 and 5, two light emitting means, for example, visible rays light emitting diode,

3

**0 115 184**

infrared light emitting diode, are shown by the reference letters 3A and 3B. Two pairs of the light detecting means consisting of a plurality of photocells for detecting the reflected rays 16b and 17b are shown by the reference letters 5a and 5b, and 5c and 5d, for example, photo-transistors, or photo-diodes. The reduction lens, i.e., the exposure lens for projecting the light beam 10a, is shown by the reference numeral 10. The first and second half-mirrors provided in parallel with the surface of the wafer 2 are shown by the reference numerals 14 and 15. Each of the detecting means 5a and 5b, and 5c and 5d, and the first and second half-mirrors 14 and 15, are located at a position symmetric to the center axis of the light beam 10a, respectively. The reference letter $L_1$ shows the distance between the focal point and the detecting means 5. The reference numerals 11, 12 and 13 show the focal surfaces. The numeral 11 shows the normal focus condition, the numeral 12 shows the rear focus condition, and the numeral 13 shows the front focus condition. Two adders 16 and 17 are provided for adding each output signal generating from the detecting means 5a and 5d, and 5b and 5c. The outputs of each adder 16 and 17 are amplified by each alternate amplifier 18 and 19, and the outputs of each alternate amplifier 18 and 19 are applied to the subtractor 20. The output of an oscillator 23 is applied to a switching circuit 24 for switching the output of the oscillator 23, and the output of the switching circuit 24 is applied to the light emitting means 3A and 3B to alternately light 3A and 3B. At the same time, the output of the switching circuit 24 is applied to a synchronous detecting circuit 21. The synchronous detecting circuit 21 synchronously detects the outputs of the switching circuit 24 and the subtractor 20. The synchronous output of the synchronous detecting circuit 21 is applied to a smoothing circuit 22, and its output is applied to a servo amplifier 25. A drive motor 26 for controlling the position of the X—Y table 1 (shown in Fig. 1) is controlled by the output signal of the servo amplifier 25.

In Fig. 4, since the wavelength of the light emitted by the first light emitting means 3A is the same as the wavelength of the light emitted by the second light emitting means 3B, they are lit alternately. However, when the wavelength of 3A differs from the wavelength of 3B, no alternate lighting is necessary, and the half-mirrors 14, 15 shown in Fig. 5 are not necessary. The operation of the device and the optical system shown in Figs. 4 and 5 will be explained below.

Figure 6 illustrates the waveform of the front focus condition when the position of the focal point is located on the surface 13 shown in Fig. 5.

Referring to Fig. 6, when the light emitting means 3A emits the light having the waveform such as "A" shown in (1), the light emitted from 3A is reflected by the first half-mirror 14, and the incident rays 16a reflected by the half-mirror 14 are again reflected by the surface 13. The reflected rays 16b shown by the chain dotted line are almost all detected by the photocell 5c. The output of the photocell 5c then obtains a high level output waveform such as "c" shown in (2). Meanwhile, the output of the photocell 5d obtains a low level output waveform such as "d" shown in (3), because the reflected rays 16b are intercepted by the second half-mirror 15. These output waveforms "c" and "d" are applied to each adder 16 and 17 and the subtractor 20, and the differential signal output waveform (c—d) shown in (4) is obtained from the output of the subtractor 20.

When the light emitting means 3A extinguishes the light based on the signal transmitted from the switching circuit 24, the light emitting means 3B emits a light having the waveform such as "B" shown in (1). The light emitted from 3B is reflected by the second half-mirror 15. The incident rays 17a reflected by the mirror 15 are again reflected by the surface 13, and the reflected rays 17b shown by the chain dotted line are almost all detected by the photocell 5b. The output of the photocell 5b then obtains a high level waveform such as "b" shown in (2). The output of the photocell 5a obtains a low level waveform such as "a" shown in (3), because the reflected rays 17b are intercepted by the first half-mirror 14. These output waveforms "a" and "b" are applied to each adder 16 and 17 and the subtractor 20. The differential signal waveform (b—a) shown in (4) is obtained from the output of the subtractor 20.

As mentioned above, the light emitting means 3A and 3B alternately emit the light based on the signal transmitted from the switching circuit 24, the output obtained from the detecting means 5a, 5b, 5c and 5d are applied to the subtractor 20 via each of the adders 16, 17, the output of the subtractor 20 is applied to the synchronous detecting circuit 21, and the output of the synchronous detecting circuit 21 is applied to the smoothing circuit 22. The output level indicating the constant positive voltage shown in (5) is obtained from the output of the smoothing circuit 22.

Accordingly, when the reflectivity of the wafer 2 is constant and the position of the focal point is located on the front focus condition, the output of the smoothing circuit 22 indicates the constant positive voltage, and the height of the X—Y table 1 is adjusted by the servo amplifier 25 and the drive motor 26 so as to cause the table to descent until the plus output level of the smoothing circuit 24 is equal to a zero voltage level. Consequently, the surface 13 of the wafer 2 is adjusted to the focal point of the surface 11.

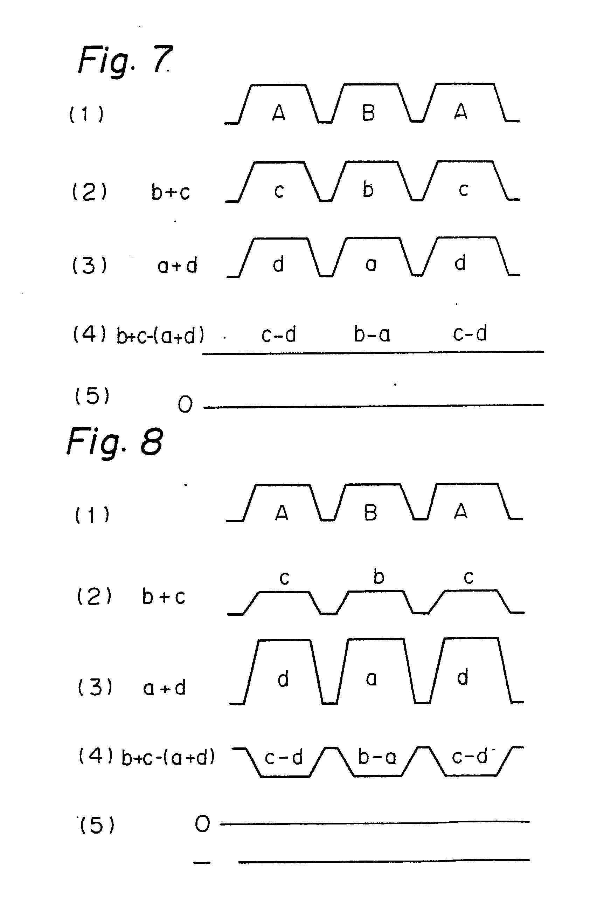

Figure 7 illustrates the waveform of the normal focus condition when the position of the focal point is located on the surface 11 shows in Fig. 5. In this case, since the first and second half-mirrors 14 and 15 are positioned to the center portion of the light path, i.e., both reflected rays 16b and 17b, the detecting means 5a and 5b, and 5c and 5d detect the same amount of light. Accordingly, when the light emitting means 3A emits a light having the waveform such as "A" shown in (1), the output of the photocells 5c and 5d obtain the high level waveforms such as "c" and "d" shown in (2) and (3). Similarly, when the light emitting means 3B emits a light having the waveform such as "b" shown in (1), the output of the photocells 5a and 5b obtains the same high level waveform as "c" and "d", such as "a" and "b" shown in (2) and (3). These

4

outputs obtained from the detecting means 5a, 5b, 5c, and 5d which are applied to the subtractor 20 via each of the adders 16 and 17, and the differential signal waveforms (c—d) and (b—a) shown in (4), are obtained from the output of the subtractor 20. The output of the subtractor 20 is applied to the smoothing circuit 22 via the synchronous detecting circuit 21, and the zero voltage output shown in (5) is obtained from the output of the smoothing circuit 22.

When the reflectivity of the wafer 2 is constant and the position of the focal point is located on the normal focus condition, the output of the smoothing circuit 22 indicates the zero level, and the height of the X—Y table 1 remains unchanged.

Figure 8 illustrates the waveform of the rear focus condition when the position of the focal point is located on the surface 12 shown in Fig. 5. In this case, since the first and second half-mirrors 14 and 15 are located at positions opposed to those for the front focus condition as mentioned in Fig. 6, the outputs of the photocells 5a, 5b, 5c and 5d obtain the inverse high level waveform such as "a", "b", "c", and "d" shown in (2) and (3). The outputs obtained from the detecting means are applied to the subtractor 20 via each of the adders 16 and 17, and the differential signal waveforms (c—d) and (b—a) shown in (4) are obtained from the output of the subtractor 20. The output of the subtractor 20 is applied to the smoothing circuit 22 via the synchronous detecting circuit 21, and the output level indicating the constant negative voltage shown in (5) is obtained from the output of the smoothing circuit 22.

When the reflectivity of the wafer 2 is constant and the position of the focal point is located on the rear focus condition, the output of the smoothing circuit 22 indicates the constant negative voltage, and the height of the X—Y table 1 is controlled by the servo amplifier 25 and the drive motor 26 so as to cause the table to elevate until the negative output level of the smoothing circuit 24 is equal to the zero voltage level. Consequently, the surface 13 of the wafer 2 is adjusted to the focal point of the surface 11.

Another case, in which the surface of the wafer 2 is inclined, as shown in Fig. 9, will be explained below.

Referring to Fig. 9, when the reflecting surface of the wafer 2 is horizontal, as shown by the actual line, both reflected rays 27b and 28b emitted alternately from the light emitting means 3A and 3B are detected by the photocells 5a and 5b, and 5c and 5d, and the zero level output is obtained from the smoothing circuit 22 as mentioned in Fig. 7. However, when the reflecting surface of the wafer 2 is inclined (as shown by the dotted line 2a) having the inclined angle δ, the incident rays 27a are reflected by the surface 2a, and almost all the reflected rays 27b are detected by the photocell 5d, but only a few are detected by the photocell 5c. Similarly, the incident rays 28a are reflected by the surface 2a, and almost all the reflected rays 28b are detected by the photocell 5b, but only a few are detected by the photocell 5a. The output levels of the detecting means 5a, 5b, 5c and 5d are then as shown in Fig. 10 (2) and (3) and are applied to the subtractor 20 via each of the adders 16 and 17. The differential signal waveforms (c—d) and (b—a) shown in Fig. 10 (4) are obtained from the output of the subtractor 20. The output of the subtractor 20 is applied to the smoothing circuit 22 via the synchronous detecting circuit 21, and the zero level output shown in Fig. 10 (5) is obtained from the output of the smoothing circuit 22. Consequently, when the position of the focal point is located on the surface of the normal focus codition, even if the reflecting surface of the wafer is inclined toward any direction, the height of the X—Y table 1 is not altered by the servo amplifier 25 and the drive motor 26.

Still another case where the position of the focal part is adjusted to the normal focus condition, but the reflectivity of the surface of the wafer is uneven is given below.

Referring to Fig. 11, on the reflecting surface 2a of the wafer 2, assuming that the portion shown as 29a has the reflectivity $R_1$, the portion shown as 29b has the reflectivity $R_2$, and $R_1$ is larger than $R_2$.

As mentioned above, when the light emitting means 3A emits light, the light is reflected by the first half-mirror 14, the incident rays 31a and 31b shown by an oblique line are reflected by the reflecting surfaces 29a and 29b having different reflectivities, respectively, and the reflected rays 30b shown by the oblique life and 30a are detected by the photocells 5c and 5d via the second half-mirror 15. Meanwhile, in the case of the reflectivity $R_1$ of high reflectivity portion and the reflectivity $R_2$ of low reflectivity portion, when the focal area having width l, length m is focussed on the surface of the wafer by the light emitting means 3A and 3B, the luminous fluxes la to ld respectively detected by the light detecting means 5a, 5b, 5c and 5d are represented by:

$$la = R_2 lm/2$$
$$lb = R_1 lm/2$$
$$lc = R_2 lm/2$$
$$ld = R_1 lm/2$$

thus,

$$lb + lc - (la + ld) = 1/2\{lm(R_1 - R_2) - lm(R_1 + R_2)\}.$$

The focal point is adjusted accordingly. In this case, since the reflectivity $R_1$ of 29a is larger than that of 29b, the photocell 5d detects a larger luminous flux than that detected by the photocell 5c. Thus the output obtained from the photocell 5d has a higher level waveform than that of the photocell 5c, as shown in Fig. 10 (2) and (3).

Similarly, when the light emitting means 3B emits light, the light is reflected by the second half-mirror 15, the incident rays 30a and 30b are reflected by the reflecting surfaces 29a and 29b, and the reflected rays 31a and 31b are detected by the photocells 5a and 5b via the first half-mirror 14. Thus, as mentioned above, the output obtained from the photocell 5b has a higher level waveform than that of the photocell 5a, as shown in Fig. 10 (2) and (3).

As shown in Fig. 10, the zero level shown in (5) is obtained from the output of the smoothing circuit 22, and the height of the X—Y table 1 is not altered by the servo amplifier 25 and the drive motor 26.

Assuming that the position of the focal point is located on the front focus condition shown by dotted line in Fig. 11, and the reflectivities $R_1$ and $R_2$ are in the above-mentioned condition, when the luminous flux of each photocells 5a, 5b, 5c and 5d is represented by Ia', Ib', Ic' and Id', respectively, and the displacement of the focal point is represented by $\delta$,

$$Ia'=R_2(Im/2-2\delta l/\tan\,\theta)$$
$$Ib'=R_1(Im/2+\delta l/\tan\,\theta)+R_2\delta l/\tan\,\theta$$

similarly,

$$Ic'=R_2(Im/2+\delta l/\tan\,\theta)+R_1\delta l/\tan\,\theta$$
$$Id'=R_1(Im/2-2\delta l/\tan\,\theta)$$
$$Ib'+Ic'-(Ia'+Id')=4\delta l(R_1+R_2)/\tan\,\theta.$$

Accordingly, when in the front focus condition, the control signal is obtained by the above-mentioned procedure. The waveforms in this case are shown in Fig. 12, the waveform level shown by (b+c)−(a+d) obtained from the output of the smoothing circuit 22 indicates the positive level output shown in (5), whereby the height of the X—Y table 1 is adjusted by the servo amplifier 25 and the drive motor 26.

## Claims

1. An automatic focus control device used in an exposure apparatus, comprising:
a first light emitting means (3A) for directing a first light ray (16a) onto a sample (2);
a second light emitting means (3B) for directing a second light ray (17a) onto said sample;
a first light detecting means for detecting said second light ray reflected by a surface of said sample, said first light detecting means being composed of a first light detecting element (5a) and a second light detecting element (5b);
a second light detecting means for detecting said first light ray reflected by said surface of said sample, said second light detecting means being composed of a third light detecting element (5c) and a fourth light detecting element (5d);
wherein said first light emitting means and said first light detecting means are located at a position symmetric to said second light emitting means and said second light detecting means with regard to a centre axis of a light beam (10a) for exposing said sample;
and means for computing the height position of the surface of said sample with respect to the position of the focus of the said exposing light beam on the basis of the output of said first and second light detecting means;
said computing means comprising a first adder (16) for adding the outputs of said first light detecting element (5a) and of said fourth light detecting element (5d), a second adder (17) for adding the output of said second light detecting element (5b) and of said third light detecting element (5c), a subtractor (20) for forming the difference between the output of said first adder and the output of said second adder, and a smoothing circuit (22) for smoothing the output of said subtractor for use as a signal for adjusting the relative height position between the focus of said exposing light beam and the surface of said sample;
whereby the output of said computing means is insensitive to an inclination of said surface of the sample and to uneven reflectivity of said surface in the region of the focal point.

2. An automatic focus control device as claimed in claim 1, characterized in that it further comprises a first half-mirror (14) and a second half-mirror (15), that said first light ray (16a) is directed to said sample (2) after being reflected by said first half-mirror (14), is reflected by said sample and impinges on said second light detecting means (5d, 5c) after having passed said second half-mirror (15) and that said second light ray (17a) is directed to said sample (2) after being reflected by said second half-mirror (15), is reflected by said sample (2) and impinges on said first light detecting means (5a, 5b) after having passed said first half-mirror.

3. An automatic focus control device as claimed in claim 2, characterized in that the wavelength of said first light ray (16a) is the same as the wavelength of said second light ray (17a).

4. An automatic focus control device as claimed in any of the preceding claims, characterized in that said first light emitting means (3A) and said second light emitting means (3B) are lit alternately.

5. An automatic focus control device as claimed in claim 1, characterized in that the wavelength of said first light ray (16a) differs from the wavelength of said second light ray (17a) in order to avoid interference with each other.

6. An automatic focus control device as claimed in any of the preceding claims, characterized in that each of said first and second light emitting means (3A, 3B) consists of an infrared light emitting diode.

7. An automatic focus control device as claimed in any of the preceding claims, characterized in that each of said light detecting elements (5a—5d) consists of a photo-transistor.

8. An automatic focus control device as claimed in any of the preceding claims, characterized in that each of said light detecting elements (5a—5d) consists of a photo-diode.

**Patentansprüche**

1. Automatische Fokussierungsvorrichtung in einem Belichtungsapparat mit:

einer ersten lichtemittierenden Einrichtung (3A), um einen ersten Lichtstrahl (16a) auf eine Probe (2) zu richten;

einer zweiten lichtemittierenden Einrichtung (3B) um einen zweiten Lichtstrahl (17a) auf die genannte Probe zu richten;

einer ersten Lichtdetektoreinrichtung zum Detektieren des genannten zweiten Lichtstrahles, der von einer Oberfläche der genannten Probe reflektiert wird, wobei die genannte erste Lichtdetektoreinrichtung zusammengesetzt ist aus einem ersten lichtdetektierenden Element (5a) und einem zweiten lichtdetektierenden Element (5b);

einer zweiten Lichtdetektoreinrichtung zum Detektieren des genannten ersten Lichtstrahles, welcher von einer Oberfläche der genannten Probe reflektiert wird, wobei die genannte zweite Lichtdetektoreinrichtung zusammengesetzt ist aus einem dritten lichtdektierenden Element (5c) und einem vierten lichtdetektierenden Element (5d);

bei welcher die genannte erste lichtemittierende Einrichtung und die genannte erste Lichtdetektoreinrichtung an Positionen angeordnet sind, die symmetrisch zu der genannten zweiten lichtemittierenden Einrichtung und der genannten zweiten Lichtdetektoreinrichtung in bezug auf eine zentrale Achse eines Lichtstrahles (10a) zur Belichtung der Probe sind;

und Einrichtungen zur Berechnung der Höhenposition der Oberfläche der genannten Probe in bezug auf die Position des Brennpunkts des genannten belichtenden Lichtstrahls auf der Basis des Ausgangs der ersten und zweiten Lichtdetektoreinrichtungen;

bei welcher die genannte Berechnungseinrichtung einen ersten Addierer (16) zum Addieren der Ausgänge des genannten ersten Lichtdetektorelements (5a) und des genannten vierten Lichtdetektorelements (5d), einen zweiten Addierer (17) zum Addieren des Ausgangs des genannten zweiten Lichtdetektorelements (5b) und des genannten dritten Lichtdetektorelements (5c) umfaßt, und einen Subtraktor (20) zur Bildung der Differenz zwischen dem Ausgang des genannten ersten Addierers und dem Ausgang des genannten zweiten Addierers, und eine Glättungsschaltung (22) zum Glätten des Ausgangs des genannten Subtraktors zur Verwendung als ein Signal zum Einstellen der relativen Höhenposition zwischen dem Fokus des genannten belichtenden Lichtstrahls und de Oberfläche der genannten Probe;

wodurch der Ausgang der genannten Berechnungseinrichtung unempfindlich gegenüber einer Neigung der genannten Oberfläche der Probe und einer ungleichmäßigen Reflektivität der genannten Oberfläche in dem Bereich des Brennpunktes ist.

2. Automatische Fokussiervorrichtung nach Anspruch 1, dadurch gekennzeichnet, daß sie ferner einen ersten Halbspiegel (14) und eine zweiten Halbspiegel (15) umfaßt, daß der genannte erste Lichtstrahl (16a) auf die genannte Probe (2) gerichtet ist, nachdem er von dem ersten Halbspiegel (14) reflektiert wurde, von der genannten Probe reflektiert wird und auf die zweite Lichtdetektoreinrichtung (5d, 5c) auftrifft, nachdem er durch den zweiten Halbspiegel (15) hindurchgetreten ist, und daß der genannte zweite Lichtstrahl (17a) auf die genannte Probe (2) gerichtet ist, nachdem er von dem genannte Halbspiegel (15) reflektiert wurde, von der genannten Probe (2) reflektiert wird und auf die genannte erste Lichtdetektoreinrichtung (5a, 5b) auftrifft, nachdem er durch den genannten ersten Halbspiegel hindurchgetreten ist.

3. Automatische Fokussiervorrichtung nach Anspruch 2, dadurch gekennzeichnet, daß die Wellenlänge des ersten Lichtstrahls (16a) dieselbe wie die Wellenlänge des zweiten Lichtstrahls (17a) ist.

4. Automatische Fokussiervorrichtung nach einem der vorhergehenden Ansprüche, dadurch gekennzeichnet, daß die genannte erste lichtemittierende Einrichtung (3A) und die genannte zweite lichtemittierende Einrichtung (3B) alternativ eingeschaltet werden.

5. Automatische Fokussiervorrichtung nach Anspruch 1, dadurch gekennzeichnet, daß die Wellenlänge des genannten ersten Lichtstrahls (16a) von der Wellenlänge des genannten zweiten Lichtstrahls (17a) differiert, um Interferenz miteinander zu vermeiden.

6. Automatische Fokussiervorrichtung nach einem der vorhergehenden Ansprüche, dadurch gekennzeichnet, daß jede der ersten und zweiten lichtemittierenden Einrichtungen (3A, 3B) aus einer infrarotes Licht emittierenden Diode besteht.

7. Automatische Fokussiervorrichtung nach einem der vorhergehenden Ansprüche, dadurch gekennzeichnet, daß jedes der lichtdetektierenden Elemente (5a—5d) aus einem Phototransistor besteht.

8. Automatische Fokussiervorrichtung nach einem der vorhergehenden Ansprüche, dadurch gekennzeichnet, daß jedes der lichtdetektierenden Elemente (5a—5d) aus einer Photodiode besteht.

**Revendications**

1. Dispositif de commande de focalisation automatique utilisé dans un appareil d'exposition, comprenant:

un premier moyen émetteur de lumière (3A) pour diriger un premier rayon lumineux (16a) sur un échantillon (2);

un second moyen émetteur de lumière (3B) pour diriger un second rayon lumineux (17a) sur l'échantillon;

un premier moyen détecteur de lumière pour détecter le second rayon lumineux réfléchi par une surface de l'échantillon, le premier moyen détecteur de lumière étant constitué d'un premier élément détecteur de lumière (5a) et d'un deuxième élément détecteur de lumière (5b);

un second moyen détecteur de lumière pour détecter le premier rayon lumineux réfléchi par la surface de l'échantillon, le second moyen détecteur de lumière étant constitué d'un troisième élément détecteur de lumière (5c) et d'un quatrième élément détecteur de lumière (5d);

dans lequel le premier moyen émetteur de lumière et le premier moyen détecteur de lumière sont situés à une position symétrique du second moyen émetteur de lumière et du second moyen détecteur de lumière par rapport à un axe central d'un faisceau lumineux (10a) servant à exposer l'échantillon;

et un moyen pour calculer la position en hauteur de la surface de l'échantillon par rapport à la position du foyer du faisceau lumineux d'exposition en fonction des signaux de sortie des premier et second moyens détecteurs de lumière;

le moyen de calcul comprenant un premier additionneur (16) pour additionner les signaux de sortie du premier élément détecteur de lumière (5a) et du quatrième élément détecteur de lumière (5d), un second additionneur (17) pour additionner les signaux de sortie du deuxième élément détecteur de lumière (5b) et du troisième élément détecteur de lumière (5c), un soustracteur (20) pour former la différence entre le signal de sortie du premier additionneur et le signal de sortie du second additonneur, et un circuit de filtrate (22) pour filtrer le signal de sortie du soustracteur afin qu'il serve de signal de réglage de la position relative en hauteur entre le foyer du faisceau lumineux d'exposition et la surface de l'échantillon;

le signal de sortie du moyen de calcul étant ainsi insensible à une inclinaison de la surface de l'échantillon et à un coefficient de réflexion inégal de la surface dans la région du point focal.

2. Dispositif de commande de focalisation automatique selon la revendication 1, caractérisé en ce qu'il comprend en outre un premier demi-miroir (14) et un second demi-miroir (15), en ce que le premier rayon lumineux (16a) est dirigé jusqu'à l'échantillon (2) après avoir été réfléchi par le premier demi-miroir (14), est réfléchi par l'échantillon et arrive sur le second moyen détecteur de lumière (5d, 5c) après être passé le second demi-miroir (15), et en ce que le second rayon lumineux (17a) est dirigé jusqu'à l'échantillon (2) après avoir été réfléchi par le second demi-miroir (15), est réfléchi par l'échantillon (2) et arrive sur le premier moyen détecteur de lumière (5a, 5b) après être passé par le premier demi-miroir.

3. Dispositif de commande de focalisation automatique selon la revendication 2, caractérisé en ce que la longueur d'onde du premier rayon lumineux (16a) est identique à la longueur d'onde du second rayon lumineux (17a).

4. Dispositif de commande de focalisation automatique selon l'une quelconque des revendications 1 à 3, caractérisé en ce que le premier moyen émetteur de lumière (3A) et le second moyen émetteur de lumière (3B) sont allumés alternativement.

5. Dispositif de commande de focalisation automatique selon la revendication 1, caractérisé en ce que la longueur d'onde du premier rayon lumineux (16a) diffère de la longueur d'onde du second rayon lumineux (17a) afin d'éviter une interférence entre eux.

6. Dispositif de commande de focalisation automatique selon l'une quelconque des revendications 1 à 5, caractérisé en ce que chacun des premier et second moyens émetteurs de lumière (3A, 3B) est constitué d'une diode émettant de la lumière infrarouge.

7. Dispositif de commande de focalisation automatique selon l'une quelconque des revendications 1 à 6, caractérisé en ce que chacun des éléments détecteurs de lumière (5a—5d) est constitué d'un phototransistor.

8. Dispositif de commande de focalisation automatique selon l'une quelconque des revendications 1 à 7, caractérisé en ce que chacun des éléments détecteurs de lumière (5a—5d) est constitué d'une photodiode.

# Fig. 1

# Fig. 2

# Fig. 3

Fig. 4

## Fig. 5

## Fig. 6

(1)  A  B  A

(2) b + c  c  b  c

(3) a + d  d  a  d

(4) b+c-(a+d)  c-d  b-a  c-d

(5)  +
O

## Fig. 7

(1)    A   B   A

(2)   b+c    c   b   c

(3)   a+d    d   a   d

(4) b+c-(a+d)    c-d    b-a    c-d

(5)    0

## Fig. 8

(1)    A   B   A

(2)   b+c    c   b   c

(3)   a+d    d   a   d

(4) b+c-(a+d)    c-d    b-a    c-d

(5)    0

## Fig. 9

## Fig. 10

(1)

(2)  b + c

(3)  a + d

(4) b+c-(a+d)

(5)  0

# Fig. 11

# Fig. 12

(1)

(2) b + c

(3) a + d

(4) b+c -(a+b)

(5)